# EUROPEAN PATENT APPLICATION

(11) **EP 2 254 153 A1**
(43) Date of publication of application: **24.11.2010**
(21) Application number: 10163320.4
(22) Date of filing: 19.05.2010
(51) Int. Cl.: H01L 27/142, H01L 31/042

(54) **See-through thin film solar module**

(30) Priority: 21.05.2009 CN 200920154558 U; 21.05.2009 CN 200920154557 U; 21.05.2009 CN 200920154556 U
(71) Applicant: Wuxi Suntech Power Co., Ltd., New District Wuxi Jiangsu 214-028 (CN); Suntech Power Co., Ltd., Shanghai Jiangsu 201112 (CN)
(72) Inventor: Li, Zhigang, 201112 Shanghai (CN); Yun, Min, 214028 Wuxi (CN); Yu, Huacong, 201112 Shanghai (CN); Song, Xianzhong, 201112 Shanghai (CN)
(74) Representative: Solf, Alexander

(57) **Abstract**

This invention discloses a thin film solar module of see-through structure comprising a solar cell segment and a light-transmitting region, wherein the solar cell segment comprises an insulating transparent substrate, a first electrode layer, a semiconductor layer and a second electrode layer that are sequentially deposited on the insulating transparent substrate, namely, the solar cell segment comprises a plurality of photo-electric conversion units connected in serial; and wherein the light-transmitting region comprises a plurality of light-transmitting square holes that are formed by partly removing the second electrode layer and the semiconductor layer in the solar cell segment. The see-through thin film solar module of this invention, besides ensuring the light-transmitting required for curtain walls of architectures, can improve the uneven distribution of energy when circular light-transmitting holes are formed using laser and solve the problem that a short circuit can easily occur in a see-through thin film solar module, thereby enhancing its power generation performance.

## Description

### Technical field

This invention relates to the field of solar photovoltaic module, particularly to a thin film solar module of see-through structure.

### Background art

In recent years, as traditional fossil fuels are running short and the global environment problem becomes increasingly severe due to mass consumption of fossil fuels, developing alternative green energy has become a major plan for each country. Solar photovoltaic power generation technologies using the photo-electric conversion effect have been developed quickly and are widely used in practice. In particular, integrating the solar power generation device with buildings to form a photovoltaic curtain wall has great significance to various functions of the buildings, such as power generation, lighting and heat insulating. Thin film solar modules, thanks to its low cost and attractive appearance, become a main choice for photovoltaic curtain walls. Current thin film solar module technologies have acquired great breakthroughs. Together with improved power output performance of a thin film solar module, its light-transmitting required for a curtain wall of building is getting closer attention. However, the inventor of this invention finds at least the following problems of the prior arts:

The light-transmitting region of a thin film solar module of see-through structure is usually formed by circular light-transmitting holes that are linearly arranged. The shortage of variations fails to achieve a good appearance.

When the circular light spots are formed by laser, the energy is unevenly distributed due to Gaussian distribution of laser energy. Thus, the films are unevenly etched by laser and the thin film solar module is prone to have a short circuit, thereby affecting the power output performance of the thin film solar module of see-through structure.

### Summary of the invention

In order to solve the above problems of the prior arts, this invention aims to provide a thin film solar module of see-through structure with both good light-transmitting and power output performance.

Another aspect of this invention is to provide a thin film solar module of see-through structure with beautiful appearance which will not affect the light-transmitting and power output performance thereof.

According to the above objects of this invention, this invention provides a thin film solar module of see-through structure comprising a solar cell segment and a light-transmitting region, wherein the solar cell segment comprises an insulating transparent substrate, a first electrode layer, a semiconductor layer and a second electrode layer that are sequentially deposited on the insulating transparent substrate; and wherein the light-transmitting region comprises a plurality of light-transmitting square holes that are formed by partly removing the second electrode layer and the semiconductor layer.

Preferably, the total area of the light-transmitting square holes accounts for 10%-30% of the area of the solar cell segment.

Preferably, the size of each light-transmitting square hole is 250µm×250µm±10%, or 150µm×150µm±10%, or 100µm×100µm±10%.

Preferably, the light-transmitting square holes overlap with each other in a linear direction to form linear light-transmitting grooves.

Preferably, the distance between adjacent linear light-transmitting grooves is 0.2mm-25mm.

Preferably, the plurality of light-transmitting square holes are linearly arranged with a center-to-center spacing of 1.01-2 times of the width of the light-transmitting square hole.

Preferably, the distance between adjacent lines formed by the plurality of light-transmitting square holes is 0.2mm-25mm.

Preferably, the plurality of light-transmitting square holes form curved lines.

Preferably, the plurality of light-transmitting square holes overlap with each other in a curved direction to form curved light-transmitting grooves.

Preferably, the distance between adjacent curved light-transmitting grooves is 0.2mm-25mm.

Preferably, the plurality of light-transmitting square holes are arranged to form curved lines with center-to-center spacing of 1.01-2 times of the width of the light-transmitting square hole.

Preferably, the distance between adjacent curved lines formed by the plurality of light-transmitting square holes is 0.2mm-25mm.

According to another aspect of this invention, this invention also provides a thin film solar module of see-through structure comprising a solar cell segment and a light-transmitting region, wherein the solar cell segment comprises an insulating transparent substrate, a first electrode layer, a semiconductor layer and a second electrode layer that are sequentially deposited on the insulating transparent substrate; wherein the light-transmitting region comprises a plurality of light-transmitting holes that are formed by partly removing the second electrode layer and the semiconductor layer in the solar cell segment; wherein the diameter of the light-transmitting hole is 100µm-250µm and the plurality of light-transmitting holes are arranged to form curved lines.

Preferably, the plurality of light-transmitting holes overlap with each other in a curved direction to form curved light-transmitting grooves.

Preferably, the distance between adjacent curved light-transmitting grooves is 0.2mm-25mm.

Preferably, the plurality of light-transmitting holes are arranged to form curved lines with center-to-center spacing of 1.01-2 times of the diameter of the light-transmitting hole.

Preferably, the distance between adjacent curved lines formed by the plurality of light-transmitting holes is 0.2mm-25mm.

Preferably, the total area of the light-transmitting holes accounts for 10%-30% of the area of the solar cell segment.

The advantageous effects of this invention are:
1. The light-transmitting square holes can improve the uneven distribution of energy when circular light-transmitting holes are formed using laser and solve the problem that a short circuit can easily occur in a thin film solar module of see-through structure, thereby enhancing the power generation performance of the thin film solar module.
2. The light-transmitting holes that are arranged in curved lines bring a beautiful appearance to the solar module and the light-transmitting and power output performance of the solar module will not be affected by its structure.

### Brief explanations of the drawings

Figure 1 is a schematic drawing of the sectional view of the thin film solar module of see-through structure of embodiment 1 of this invention;
Figure 2 is a schematic drawing of the structure of the thin film solar module of see-through structure of embodiment 1 of this invention;
Figure 3 is a schematic drawing of the structure of the thin film solar module of see-through structure of embodiment 2 of this invention;
Figure 4 is a schematic drawing of the structure of the thin film solar module of see-through structure of embodiment 3 of this invention;
Figure 5 is a schematic drawing of the structure of the thin film solar module of see-through structure of embodiment 4 of this invention;
Figure 6 is a schematic drawing of the structure of the thin film solar module of see-through structure of embodiment 5 of this invention.

### Embodiments for carrying out the invention

The followings describe the embodiments of this invention in detail with reference to the figures.

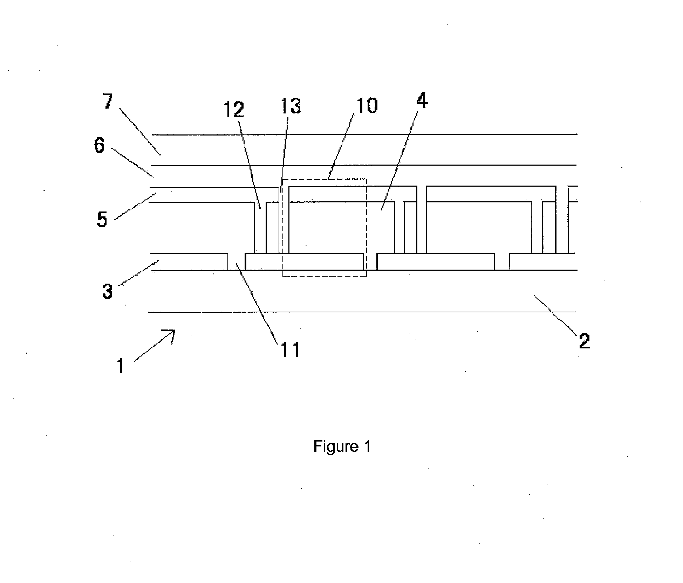

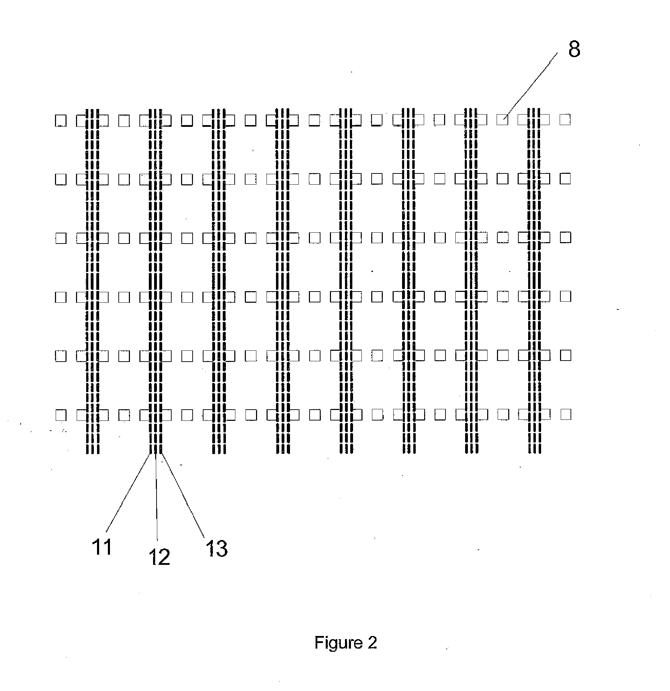

As shown in the schematic drawing of the sectional view of the thin film solar module of see-through structure of embodiment 1 of this invention in figure 1 and the schematic drawing of the structure of the thin film solar module of embodiment 1 of this invention in figure 2, the thin film solar module 1 of this embodiment comprises a solar cell segment which comprises an insulating transparent substrate 2 and a first electrode layer 3, a semiconductor layer 4 and a second electrode layer 5 that are sequentially deposited on the insulating transparent substrate 2, and a light-transmitting region. In another word, the solar cell segment comprises a plurality of photo-electric conversion units 10 connected in serial. The thin film solar module 1 further comprises a seal resin layer 6, a back encapsulation layer 7, a first open groove 11, a second open groove 12, and a third open groove 13, wherein the first open groove 11, the second open groove 12, and the third open groove 13 are parallel with each other and perpendicular to the section direction. The first open groove 11 divides the first electrode layer 3 of the thin film solar module 1 to form the plurality of photo-electric conversion units 10. During the process of forming the semiconductor layer 4, the first open groove 11 is filled with the material which forms the semiconductor layer 4 to insulate the adjacent first electrode layer. The second open groove 12 divides the semiconductor layer 4 and is filled with the conductive material which forms the second electrode layer 5 during the process of forming the second electrode layer 5, such that the second electrode layer 5 of the photo-electric conversion unit 10 is electrically connected with the first electrode layer 3 of the adjacent photo-electric conversion unit 10. The third open groove 13 divides the second electrode layers 5 of adjacent photo-electric conversion units 10 and is filled with a seal resin layer 6 when the thin film solar module is encapsulated.

To ensure the light-transmitting of the thin film solar module, after the photo-electric conversion unit is made, laser film etching is used to partly remove the second electrode layer 5 and the semiconductor layer 4 in the direction perpendicular to the first open groove 11, the second open groove 12, and the third open groove 13 to form linear light-transmitting grooves formed by independent and discrete light-transmitting square holes 8, thereby forming the light-transmitting region of the thin film solar module 1 of this Embodiment. The distance between the adjacent linear light-transmitting grooves formed by light-transmitting square holes 8 is preferably 0.2mm-25mm. If the size of the light-transmitting square hole 8 is too small, the light-transmitting requirement will not be met; if the size of the light-transmitting square hole 8 is too big, a very large laser power is needed when making the light-transmitting square holes and the effective area of the photo-electric conversion unit will be reduced. Considering the light-transmitting and the manufacturing cost, the size of the light-transmitting square hole_8 is preferably 250µm×250µm±10%, or 150µm×150µm±10%, or 100µm×100µm±10%. If the center-to-center spacing of adjacent light-transmitting square holes 8 is greater than 2 times of the side length of the light-transmitting square hole 8, the non-light-transmitting part between the adjacent light-transmitting square holes 8 can be easily identified; if the center-to-center spacing of adjacent light-transmitting square holes 8 is smaller than 1.01 times of the side length of the light-transmitting square hole 8, the residue semiconductor layer 4 and the second electrode layer 5 between the adjacent light-transmitting square holes 8 may be peeled off due to the heat generated in the laser etching process, as a result, the power output performance of the thin film solar module 1 will be lowered. In view of the above factors, adjacent light-transmitting square holes 8 are arranged with a center-to-center spacing of 1.01-2 times of the width of the light-transmitting square hole 8 along the line perpendicular to the first open groove 11, the second open groove 12, and the third open groove 13. The ratio of the total area of the light-transmitting square holes 8 to the area of the solar cell segment may be set according to the light-transmitting requirement and the power output performance requirement of the thin film solar module 1. Generally, the ratio is 1%-50%. However, if the ratio is too low, the light transmitting will be poor; and if the ratio is too high, the power output performance of the thin film solar module 1 will be affected. Therefore, the preferable ratio is 10%-30%.

The thin film solar module of see-through structure of this embodiment can improve the uneven distribution of energy when circular light-transmitting holes are formed using laser and solve the problem that a short circuit can easily occur in a see-through thin film solar module, thereby enhancing the power output performance of the thin film solar module.

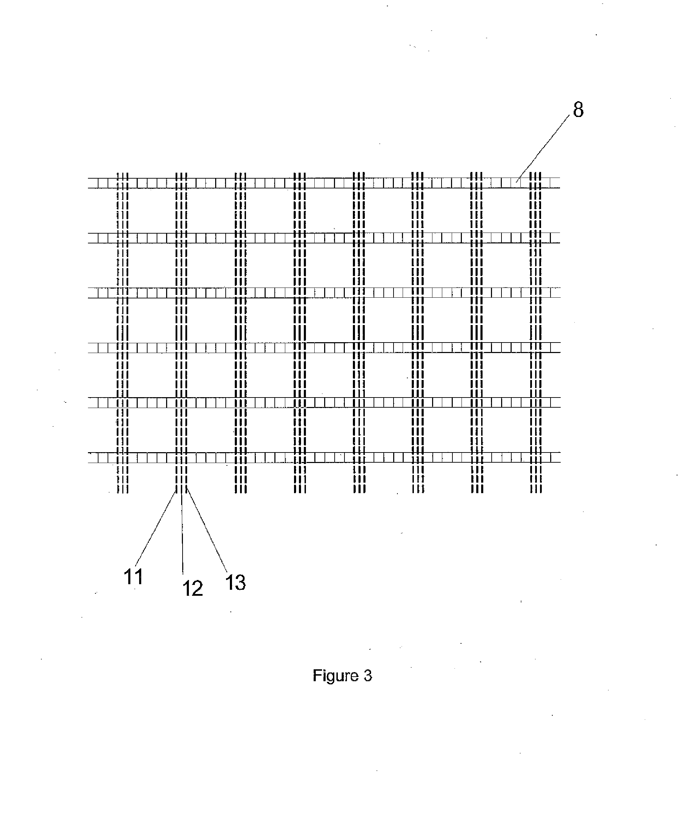

As shown in the schematic drawing of the structure of the see-through thin film solar module of Embodiment 2 of this invention in figure 3, based on embodiment 1, a linear light-transmitting groove formed of overlapped light-transmitting square holes 8 may be formed by using laser film etching in the direction perpendicular to the first open groove 11, the second open groove 12, and the third open groove 13, thereby forming a continuous linear light-transmitting groove. As described above, the size of the light-transmitting square hole 8 is preferably 250µm×250µm±10%, or 150µm×150µm±10%, or 100µm×100µm±10%, and the ratio of the total area of the light-transmitting square holes 8 to the area of the solar cell segment is preferably 10%-30%.

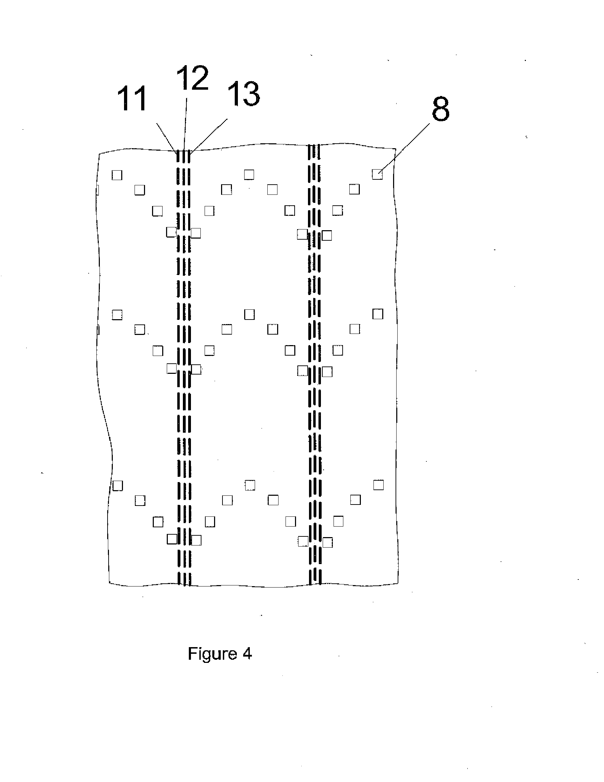

As shown in the schematic drawing of the structure of the see-through thin film solar module of Embodiment 3 of this invention in figure 4, the difference of this embodiment from Embodiment 1 is: after the photo-electric conversion unit is made, laser film etching is used to form curved light-transmitting grooves formed by independent and discrete light-transmitting square holes 8 in the axial direction perpendicular to the first open groove 11, the second open groove 12, and the third open groove 13, thereby forming the light-transmitting region of the thin film solar module 1 of this Embodiment. The distance between the adjacent curved light-transmitting grooves formed by light-transmitting square holes 8 is preferably 0.2mm-25mm. And similarly, the size of the light-transmitting square hole 8 is preferably 250µm×250µm±10%, or 150µm×150µm±10%, or 100µm×100µm±10%; and adjacent light transmitting square holes 8 are arranged to form a curve with a center-to-center spacing of 1.01-2 times of the width of the light-transmitting square hole 8, with the extension direction of the curve being perpendicular to the first open groove 11, the second open groove 12, and the third open groove 13. The ratio of the total area of the light-transmitting square holes 8 to the area of the solar cell segment preferably is 10%-30%.

The see-through thin film solar module of this embodiment can not only achieve the power output performance and light-transmitting that are not lower than those of the see-through thin film solar module of prior arts, but also possesses good appearance, thereby allowing the application of thin film solar modules to meet people's artistic aspiration for curtain walls of buildings.

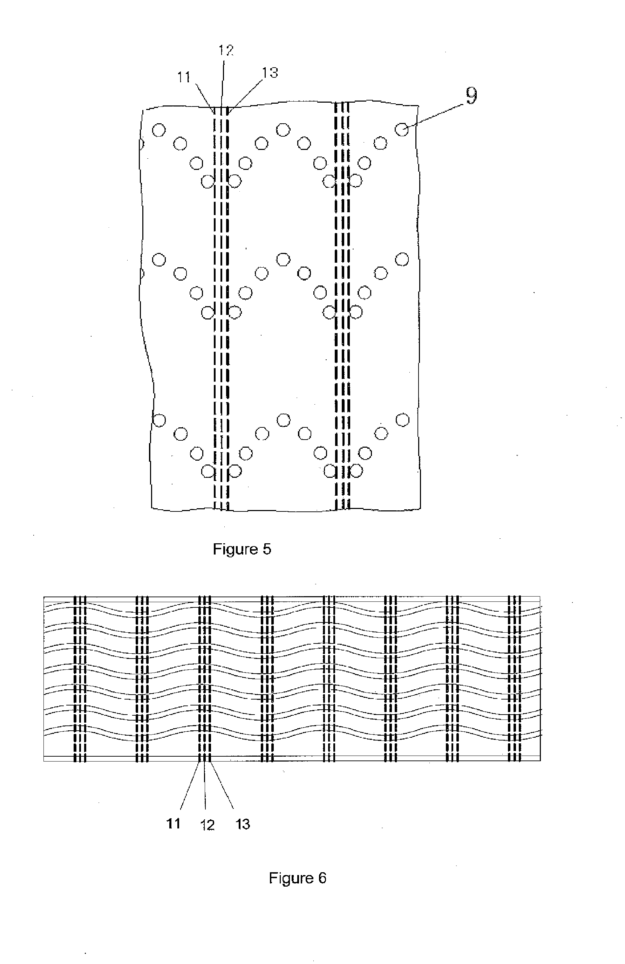

As shown in the schematic drawing of the structure of the see-through thin film solar module of Embodiment 4 of this invention in figure 5, the difference of this embodiment from Embodiment 1 is: to ensure the light-transmitting of the thin film solar module, after the photo-electric conversion unit is made, laser film etching is used to form curved light-transmitting grooves formed by independent and discrete light-transmitting holes 9 in the axial direction perpendicular to the first open groove 11, the second open groove 12, and the third open groove 13, thereby forming the light-transmitting region of the thin film solar module 1 of this Embodiment. The distance between the adjacent curved light-transmitting grooves formed by light-transmitting holes 9 is preferably 0.2mm-25mm. If the diameter of the light-transmitting hole 9 is too small, e.g. less than 30µm, the light-transmitting requirement will not be met; if the diameter of the light-transmitting hole 9 is too big, e.g. greater than 500µm, a very large laser power is needed when making the light-transmitting square holes and the effective area of the photo-electric conversion unit will be reduced. Considering the light-transmitting and the manufacturing cost, the diameter of the light-transmitting hole 9 is preferably 100µm-250µm. And similarly, the adjacent light-transmitting holes 9 are arranged with a center-to-center spacing of 1.01-2 times of the diameter of the light-transmitting hole 9. The ratio of the total area of the light-transmitting holes 9 to the area of the solar cell segment preferably is 10%-30%.

The see-through thin film solar module of this embodiment can not only achieve the power output performance and light-transmitting that are not lower than those of the see-through thin film solar module of prior arts, but also possesses good appearance, thereby allowing the application of thin film solar modules to meet people's artistic aspiration for curtain walls of architectures.

In addition, this embodiment only takes a curve formed by the light-transmitting holes as an example. It should not be difficult to understand that, to meet different requirements of customers, the light-transmitting hole or light-transmitting groove of this embodiment may be arranged in other manners that have different beautiful appearances.

As shown in the schematic drawing of the structure of the see-through thin film solar module of Embodiment 5 of this invention in figure 6, based on Embodiment 3 or 4, a curved light-transmitting groove formed of overlapped light-transmitting square holes 8 or overlapped light-transmitting holes 9 may be formed by using laser film etching in the axial direction perpendicular to the first open groove 11, the second open groove 12, and the third open groove 13, thereby forming a continuous curved light-transmitting groove. As described above, the width of the curved light-transmitting groove is preferably 100µm-250µm, and the ratio of the total area of the curved light-transmitting grooves to the area of the solar cell segment is preferably 10%-30%.

The above embodiments are only illustrative examples of this invention and are not intended to limit this invention. The scope of this invention is defined by the attached claims. A person skilled in the art may make modifications or substitutions within the spirit and protection scope of this invention. Such modifications or substitutions shall also be deemed to be within the protection scope of this invention.

## Claims

1. A thin film solar module, **characterized by** comprising a solar cell segment and a light-transmitting region, wherein the solar cell segment comprises an insulating transparent substrate, a first electrode layer, a semiconductor layer and a second electrode layer that are sequentially deposited on the insulating transparent substrate; and wherein the light-transmitting region comprises a plurality of light-transmitting square holes that are formed by partly removing the second electrode layer and the semiconductor layer.

2. The thin film solar module according to claim 1, **characterized in that** the total area of the light-transmitting square holes accounts for 10%-30% of the area of the solar cell segment.

3. The thin film solar module according to claim 1, **characterized in that** the size of each light-transmitting square hole is 250µm×250µm±10%, or 150µm×150µm±10%, or 100µm×100µm±10%.

4. The thin film solar module according to any one of claims 1-3, **characterized in that** the light-transmitting square holes overlap with each other in a linear direction to form linear light-transmitting grooves.

5. The thin film solar module according to claim 4, **characterized in that** the distance between adjacent linear light-transmitting grooves is 0.2mm-25mm.

6. The thin film solar module according to any one of claims 1-3, **characterized in that** the plurality of light-transmitting square holes are linearly arranged with a center-to-center spacing of 1.01-2 times of the width of the light-transmitting square hole.

7. The thin film solar module according to claim 6, **characterized in that** the distance between adjacent lines formed by the plurality of light-transmitting square holes is 0.2mm-25mm.

8. The thin film solar module according to any one of claims 1-3, **characterized in that** the plurality of light-transmitting square holes form curved lines.

9. The thin film solar module according to claim 8, **characterized in that** the plurality of light-transmitting square holes overlap with each other in a curved direction to form curved light-transmitting grooves.

10. The thin film solar module according to claim 9, **characterized in that** the distance between adjacent curved light-transmitting grooves is 0.2mm-25mm.

11. The thin film solar module according to claim 8, **characterized in that** the plurality of light-transmitting square holes are arranged to form curved lines with center-to-center spacing of 1.01-2 times of the width of the light-transmitting square hole.

12. The thin film solar module according to claim 11, **characterized in that** the distance between adjacent curved lines formed by the plurality of light-transmitting square holes is 0.2mm-25mm.

13. A thin film solar module, **characterized by** comprising a solar cell segment and a light-transmitting region, wherein the solar cell segment comprises an insulating transparent substrate, a first electrode layer, a semiconductor layer and a second electrode layer that are sequentially deposited on the insulating transparent substrate; wherein the light-transmitting region comprises a plurality of light-transmitting holes that are formed by partly removing the second electrode layer and the semiconductor layer in the solar cell segment; wherein the diameter of the light-transmitting hole is 100µm-250µm and the plurality of light-transmitting holes are arranged to form curved lines.

14. The thin film solar module according to claim 13, **characterized in that** the plurality of light-transmitting holes overlap with each other in a curved direction to form curved light-transmitting grooves.

15. The thin film solar module according to claim 14, **characterized in that** the distance between adjacent curved light-transmitting grooves is 0.2mm-25mm.

16. The thin film solar module according to claim 13, **characterized in that** the plurality of light-transmitting holes are arranged to form curved lines with center-to-center spacing of 1.01-2 times of the diameter of the light-transmitting hole.

17. The thin film solar module according to claim 14, **characterized in that** the distance between adjacent curved lines formed by the plurality of light-transmitting holes is 0.2mm-25mm.

18. The thin film solar module according to any one of claims 13-17, **characterized in that** the total area of the light-transmitting holes accounts for 10%-30% of the area of the solar cell segment.
